# EUROPEAN PATENT APPLICATION

(11) **EP 4 842 189 A1**
(43) Date of publication of application: **18.11.2026**
(21) Application number: 25176482.5
(22) Date of filing: 14.05.2025
(51) Int. Cl.: H10P 74/00

(54) **METHOD FOR DETERMINING A CORRECTION FOR A MANUFACTURING PROCESS AND ASSOCIATED APPARATUSES**

(71) Applicant: ASML Netherlands B.V., 5500 AH Veldhoven (NL)
(72) Inventor: TEN BERGE, Peter, 5500 AH Veldhoven (NL); KATTOUW, Hans, Erik, 5500 AH Veldhoven (NL); MOS, Everhardus, Cornelis, 5500 AH Veldhoven (NL); DILLEN, Hermanus, Adrianus, 5500 AH Veldhoven (NL); MEGENS, Henricus, Johannes, Lambertus, 5500 AH Veldhoven (NL); MACHT, Lukasz, Jerzy, 5500 AH Veldhoven (NL); JIA, Fei, 5500 AH Veldhoven (NL); VINKEN, Gerard, Christian, Marie, 5500 Veldhoven (NL); CROISET, Bavo, Asscher, 5500 AH Veldhoven (NL)
(74) Representative: ASML Netherlands B.V.

(57) **Abstract**

Disclosed is a method for determining a correction for manufacturing one or more bonded substrates. The method comprises obtaining initial bonding tool monitor data describing distortion imposed on the one or more bonded substrates by at least a first bonding tool at an initial time and second bonding tool monitor data describing distortion imposed by the first bonding tool at a second time subsequent to said initial time and/or distortion imposed by at least one second bonding tool. A correction for manufacturing one or more subsequent bonded substrates is determined using at least said first bonding tool and/or said at least one second bonding tool from the initial bonding tool monitor data and second bonding tool monitor data.

## Description

### FIELD OF INVENTION

The present invention relates to methods and apparatus for applying patterns to substrates and subsequently bonding two or more substrates together in a lithographic manufacturing process.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Process control methods are used in the manufacture of integrated devices to monitor and control the processes of application of a pattern on a substrate or measurement of such a pattern. Such process control techniques are typically performed to obtain corrections for control of the process. Subsequently, it is sometimes required (for certain devices) to bond substrates together. Bonding processes include die-to-die, die-to-wafer and wafer-to-wafer. Wafer-to-wafer bonding, where whole wafers are permanently bonded together prior to dicing, has the potential of providing a high accuracy and high throughput bonding solution.

It would be desirable to improve process control methods in the manufacture of bonded substrates comprising integrated devices.

### SUMMARY OF THE INVENTION

In a first aspect of the invention, there is provided a method for determining a correction for manufacturing one or more bonded substrates, the method comprising: obtaining initial bonding tool monitor data describing distortion imposed on the one or more bonded substrates by at least a first bonding tool at an initial time; obtaining second bonding tool monitor data describing distortion imposed by the first bonding tool at a second time subsequent to said initial time and/or distortion imposed by at least one second bonding tool; and determining a correction for manufacturing one or more subsequent bonded substrates using at least said first bonding tool and/or said at least one second bonding tool from the initial bonding tool monitor data and second bonding tool monitor data.

In a second aspect of the invention, there is provided a computer program comprising program instructions operable to perform the method of the first aspect when run on a suitable apparatus.

Further aspects of the invention comprise a processing apparatus and/or a bonded substrate manufacturing apparatus configured to run the computer program of the second aspect.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings in which:
Figure 1 depicts a lithographic apparatus together with other apparatuses forming a production facility for semiconductor devices;
Figure 2 comprises a schematic diagram of a scatterometer for use in measuring targets according to embodiments of the invention;
Figure 3 is a schematic overview of control mechanisms in a lithographic process utilizing a scanner stability module.
Figure 4 is a flow diagram describing a present method of manufacturing integrated devices which utilizes wafer-to-wafer bonding;
Figure 5 is a schematic drawing of a bonding interface detail illustrating a defect of a type of which methods disclosed herein aim to correct;
Figure 6 is a flow diagram describing methods for determining initial monitor data suitable for use as a baseline in monitoring drift of a bonding tool; and
Figure 7 is a flow diagram describing methods for monitoring drift of a bonding tool.

### DETAILED DESCRIPTION

Before describing embodiments of the invention in detail, it is instructive to present an example environment in which embodiments of the present invention may be implemented.

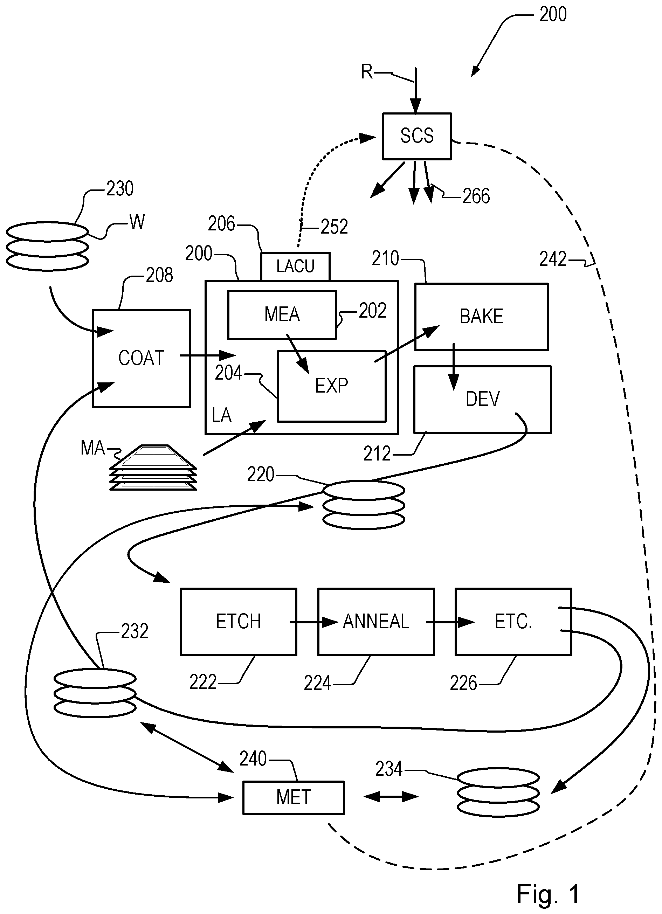

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations.. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

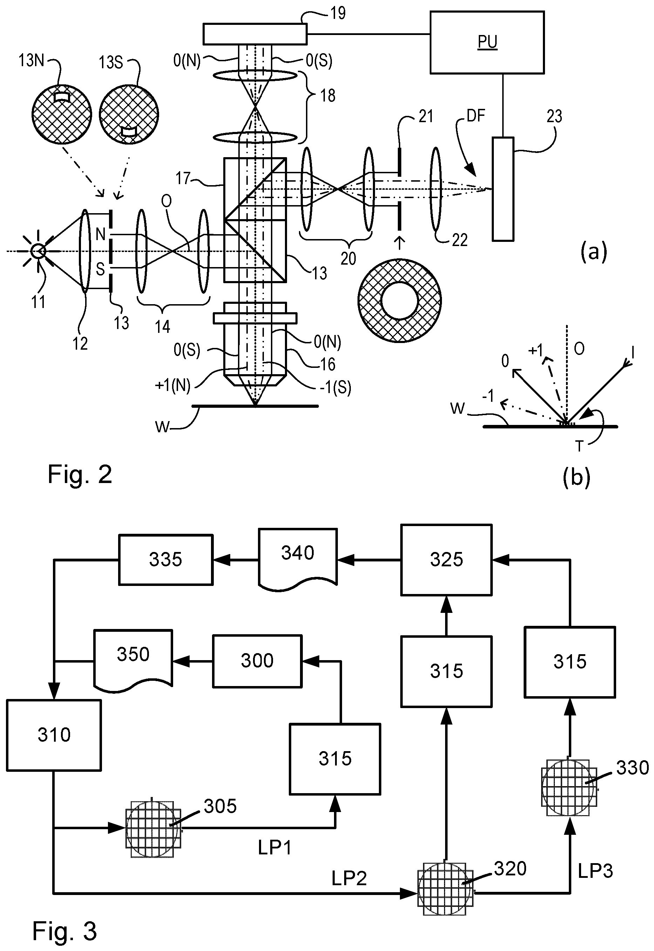

A metrology apparatus suitable for use in embodiments of the invention is shown in Figure 2(a). A target T and diffracted rays of measurement radiation used to illuminate the target are illustrated in more detail in Figure 2(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 2(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 2(a) and 2(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 2(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for many measurement purposes such as reconstruction used in methods described herein. The pupil plane image can also be used for focusing the metrology apparatus and/or normalizing intensity measurements of the first order beam.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 2 are purely examples. In another embodiment of the invention, on-axis illumination of the targets is used and an aperture stop with an off-axis aperture is used to pass substantially only one first order of diffracted light to the sensor. In yet other embodiments, 2^{nd}, 3^{rd} and higher order beams (not shown in Figure 2) can be used in measurements, instead of or in addition to the first order beams.

The target T may comprise a number of gratings, which may have differently biased overlay offsets in order to facilitate measurement of overlay between the layers in which the different parts of the composite gratings are formed. The gratings may also differ in their orientation, so as to diffract incoming radiation in X and Y directions. In one example, a target may comprise two X-direction gratings with biased overlay offsets +d and -d, and Y-direction gratings with biased overlay offsets +d and -d. Separate images of these gratings can be identified in the image captured by sensor 23. Once the separate images of the gratings have been identified, the intensities of those individual images can be measured, e.g., by averaging or summing selected pixel intensity values within the identified areas. Intensities and/or other properties of the images can be compared with one another. These results can be combined to measure different parameters of the lithographic process

Various techniques may be used to improve the accuracy of reproduction of patterns onto a substrate. Accurate reproduction of patterns onto a substrate is not the only concern in the production of ICs. Another concern is the yield, which generally measures how many functional devices a device manufacturer or a device manufacturing process can produce per substrate. Various approaches can be employed to enhance the yield. One such approach attempts to make the production of devices (e.g., imaging a portion of a design layout onto a substrate using a lithographic apparatus such as a scanner) more tolerant to perturbations of at least one of the processing parameters during processing a substrate, e.g., during imaging of a portion of a design layout onto a substrate using a lithographic apparatus. The concept of overlapping process window (OPW) is a useful tool for this approach. The production of devices (e.g., ICs) may include other steps such as substrate measurements before, after or during imaging, loading or unloading of the substrate, loading or unloading of a patterning device, positioning of a die underneath the projection optics before exposure, stepping from one die to another, etc. Further, various patterns on a patterning device may have different process windows (i.e., a space of processing parameters under which a pattern will be produced within specification). Examples of pattern specifications that relate to a potential systematic defect include checks for necking, line pull back, line thinning, CD, edge placement, overlapping, resist top loss, resist undercut and/or bridging. The process window of all or some (usually patterns within a particular area) of the patterns on a patterning device may be obtained by merging (e.g., overlapping) process windows of each individual pattern. The process window of these patterns is thus called an overlapping process window. The boundary of the OPW may contain boundaries of process windows of some of the individual patterns. In another words, these individual patterns limit the OPW. These individual patterns can be referred to as "hot spots" or "process window limiting patterns (PWLPs)," which are used interchangeably herein. When controlling a lithography process, it is possible, and typically economical, to focus on the hot spots. When the hot spots are not defective, it is likely that all the patterns are not defective. The imaging becomes more tolerant to perturbations when values of the processing parameters are closer to the OPW if the values of the processing parameters are outside the OPW, or when the values of the processing parameters are farther away from the boundary of the OPW if the values of the processing parameters are inside the OPW.

The values of the processing parameters may be selected such that they stay away from the boundary of the OPW or the fitted OPW, in order to decrease the chance that the processing parameters shift outside the OPW and thereby cause defects and decrease the yield. One approach of selecting the values of the processing parameters includes, before actual imaging, (1) optimizing the lithographic apparatus (e.g., optimizing the source and projection optics) and optimizing the design layout, (2) determining the OPW or fitted OPW (e.g., by simulation), and (3) determining a point in the space of the processing parameters (i.e., determining the values of the processing parameters) that is as far away as possible from the boundary of the OPW or fitted OPW (this point may be called the "center" of the OPW or fitted OPW).

During or before the actual imaging, the processing parameters may have a perturbation that causes them to deviate from the point that is as far away as possible from the boundary of the OPW or fitted OPW. For example, the focus may change due to topography of a substrate to be exposed, drift in the substrate stage, deformation of the projection optics, etc.; the dose may change to due drift in the source intensity, dwell time, etc. The perturbation may be large enough to cause processing parameters to be outside the OPW, and thus may lead to defects. Various techniques may be used to identify a processing parameter that is perturbed and to correct that processing parameter. For example, if the focus is perturbed, e.g., because an area of the substrate that is slightly raised from the rest of the substrate is being exposed, the substrate stage may be moved or tilted to compensate for the perturbation.

Control of the lithographic process are typically based on measurements fed back or fed forward and then modelled using, for example interfield (across-substrate fingerprint) or intrafield (across-field fingerprint) models. Within a die, there may be separate functional areas such as memory areas, logic areas, contact areas etc. Each different functional area, or different functional area type may have a different process window, each with a different processes window center. For example, different functional area types may have different heights, and therefore different best focus settings. Also, different functional area types may have different structure complexities and therefore different focus tolerances (focus process windows) around each best focus. However, each of these different functional areas will typically be formed using the same focus (or dose or position etc.) setting due to control grid resolution limitations.

Figure 3 depicts the overall lithography and metrology method incorporating a stability module 300 (essentially an application running on a server, in this example). Shown are three main process control loops, labeled LP1, LP2, LP3. The first loop LP1 provides recurrent monitoring for stability control of the lithography apparatus using the stability module 300 and monitor wafers. Immediately after a lithographic apparatus calibration, a baseline wafer or wafer set is exposed on the lithographic apparatus or scanner 310 and measured by a metrology tool 315 to set baseline parameters e.g., for focus and/or overlay (e.g., the scanner's overlay and/or focus baseline fingerprints). At a later time (e.g., periodically), a monitor wafer 305 is exposed on scanner 310 and measured by metrology tool 315. The stability module 300 compares the parameters from the monitor wafer 305 measurements (e.g., the scanner's present overlay and/or focus fingerprints) and compares these to the (stored) baseline parameters. Based on the comparison, stability module 300 calculates correction routines 350 to correct for drift in these parameters which is fed back to the scanner 310 and used when performing further exposures. This can be repeated periodically to control scanner drift, e.g., to determine corrections which return the scanner operation to (or near) the baseline parameters. The exposure of the monitor wafer may involve printing a pattern of marks on top of reference marks. By measuring overlay error between the top and bottom marks, deviations in performance of the lithographic apparatus can be measured, even when the wafers have been removed from the apparatus and placed in the metrology tool. Such monitor wafer may also comprise focus marks for monitoring of focus.

In some embodiments, the monitor wafers are dedicated to a particular lithographic apparatus. In other embodiments, a "golden reference" baseline monitor wafer is defined which can be used for all lithographic apparatuses, along with an associated difference set to adapt the baseline parameters for each individual lithographic apparatus. The stability module 300 calculates the difference (as a difference set or correction set) between the golden reference wafer and a standard monitor wafer exposed on each scanner. The standard monitor wafer plus the difference set acts as a new copy of the reference. In this manner, every scanner in a fabrication site (fab), regardless of scanner type or model and of grid differences, can be matched to this golden reference, increasing fab efficiency significantly.

The second (APC) loop is for local scanner control on-product (determining focus, dose, and overlay on product wafers). The exposed product wafer 320 is passed to metrology unit 315 where information relating for example to parameters such as critical dimension, sidewall angles and overlay is determined and passed onto the Advanced Process Control (APC) module 325. This data is also passed to the stability module 300. Process corrections 340 are made before the Manufacturing Execution System (MES) 335 takes over, providing control of the scanner 310, in communication with the scanner stability module 300.

The third control loop is to allow metrology integration into the second (APC) loop (e.g., for double patterning). The post etched wafer 330 is passed to metrology unit 315 which again measures parameters such as critical dimensions, sidewall angles and overlay, read from the wafer. These parameters are passed to the Advanced Process Control (APC) module 325. The loop continues the same as with the second loop.

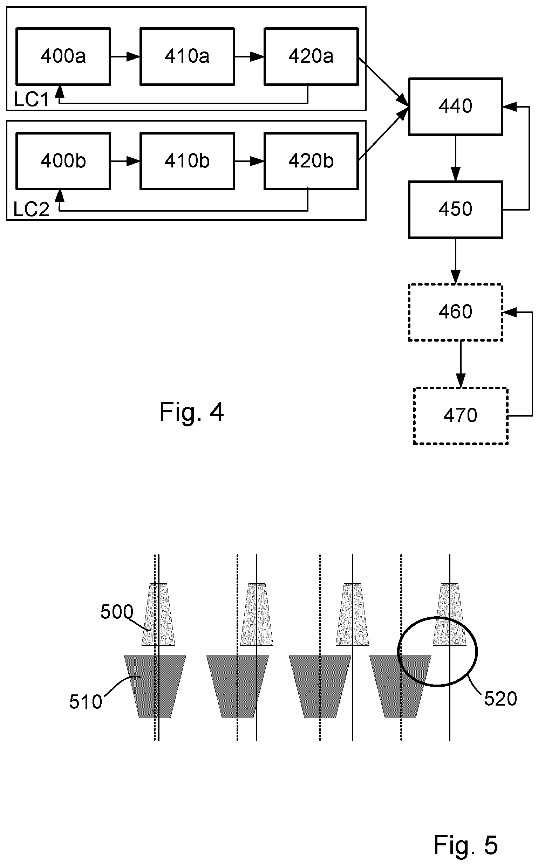

Figure 4 shows a device manufacturing arrangement for making bonded substrates (and therefore ICs based on bonded substrates) comprising a first manufacturing lithocell LC1 and a second manufacturing lithocell LC2. Within each lithocell is a respective lithographic processing system 400a, 400b and respective first metrology systems 410a, 410b. Each lithographic processing system 400a, 400b, may comprise a full patterning system; for example, an optical lithographic apparatus or scanner such as described in respect of Figure 1, a track tool, a deposition tool, an etch tool, any other apparatus used in the patterning process, or any combination selected therefrom. The systems may also each comprise a software application 420a, 420b in communication with its respective lithographic processing system 400a, 400b and metrology system 410a, 410b, so that results, designs, data, etc. of the lithographic processing system 400a, 400b and/or the metrology apparatus 410a, 410b may be stored and analyzed by the software application 420a, 420b at the same time or different times.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 400a and 400b may comprise different tools or the same tools within each respective system. Similarly metrology apparatuses 410 and 410b may be the same apparatus or different apparatuses. The software application 420a, 420b may be comprised within one or both of the respective lithographic processing systems 400a, 400b and/or one or both of the first metrology systems 410a, 410b, or elsewhere.

As mentioned above, the lithographic processing system 400a, 400b may be configured to include the lithographic apparatus LA in Figure 1. The lithographic processing system 400a, 400b may be setup for executing the patterning aspect of the patterning process and optionally, may be configured to correct for deviations occurring within the lithographic processing system 400a, 400b or in one or more other processes or apparatuses in the patterning process. The lithographic processing system 400a, 400b may be able to apply a correction of an error (e.g., imaging error, focus error, dose error, etc.) by adjusting one or more modification apparatuses of the lithographic processing system 400a, 400b. That is, correction may be made by any manufacturing processing tool in the lithographic processing system 400a, 400b that can purposefully modify a patterning error.

For example, the correction of an error can be made by adjusting one or more modification apparatuses of the lithographic apparatus, e.g., by employing an adjustment mechanism to correct for or apply an optical aberration, by employing an adjuster to correct or modify an illumination intensity distribution, by employing a positioner of a patterning device support structure and/or positioner of the wafer table to correct or modify the position of a patterning device support structure and/or wafer table WT respectively, etc. Where, for example, the lithographic processing system 400a, 400b comprises a track tool, correction of an error can be made by adjusting one or more modification apparatuses of the track tool, e.g., modifying a bake temperature of a bake tool of the track, modifying a development parameter of a development tool of the track, etc. Similarly, where, for example, the lithographic processing system 400a, 400b comprises an etch tool, correction of an error can be made by adjusting one or more modification apparatuses of the etch tool, e.g., modifying an etch parameter, such as etchant type, etchant rate, etc. Similarly, where, for example, the lithographic processing system 400a, 400b comprises a planarization tool, correction of an error can be made by adjusting one or more modification apparatuses of the planarization tool, e.g., modifying a planarization parameter. Similarly, where, for example, the lithographic processing system 400a, 400b comprises a deposition tool, correction of an error can be made by adjusting one or more modification apparatuses of the deposition tool, e.g., modifying a deposition parameter.

One or more modification apparatuses of the lithographic processing system 400a, 400b may be able to apply up to third order polynomial correction of errors (e.g., imaging error, focus error, dose error, etc.).

The metrology apparatus 410a, 410b may be configured to obtain measurements related to wafers printed with patterns by the lithographic processing system 400a, 400b. The metrology apparatus 410a, 410b may be configured to measure or determine one or more parameters (e.g., overlay error, dose, focus, CD, etc.) of the patterns printed by the lithographic processing system 400a, 400b. The metrology apparatus 410a, 410b may be a diffraction-based overlay metrology tool that can measure, e.g., overlay, critical dimension and/or other parameters. The metrology apparatus 410a, 410b may be an alignment apparatus used to measure relative position between two objects, such as between a patterning device and a wafer. The metrology apparatus 410a, 410b may be a level sensor to measure a position of a surface, e.g., a height and/or rotational position of a wafer surface. The metrology apparatus 410a, 410b may be a plurality of metrology apparatuses including any combination of these devices.

The metrology apparatus 410a, 410b may measure and/or determine one or more values of one or more parameters (e.g., overlay error, CD, focus, dose, etc.) associated with an error in the patterning process. After the metrology apparatus 410a, 410b finishes the measurement or determination, the software application 420a, 420b creates modification information based on the measurement data (e.g., overlay error, CD, focus, dose, etc.). The software application 420a, 420b may evaluate the one or more values of the one or more parameters to determine if they are within a tolerance range. If not, the software application 420a, 420b determines modification information to correct an error reflected by the out of tolerance one or more values of the one or more parameters. The software application 420a, 420b may use one or more mathematical models to determine error correctable by one or more modification apparatuses of the lithographic processing system 400a, 400b and to provide information for one or more parameters (e.g. modification information) of the one or more modification apparatuses of the lithographic processing system 400a, 400b, which one or more parameters enable configuration of the one or more modification apparatuses of the lithographic processing system 400a, 400b to correct (e.g., eliminate or reduce to within a tolerance range) the error. One or more of the mathematical models may define a set of basis functions that fit the data once parameterized. The one or more mathematical models may comprise a model configured to simulate correctable error for the lithographic processing system 400a, 400b. The model may specify a range of modifications that one or more of the modification apparatuses of the lithographic processing system 400a, 400b can make and determines correctable error within the range. That is, the range may specify an upper limit, a lower limit, and/or both on the amount of modifications that a particular modification apparatus of the lithographic processing system 400a, 400b can make.

Once pairs of substrates or wafers are completed from each of lithocell LC1 and lithocell LC2, they may be bonded together within a bonding tool 440 to obtain a bonded wafer. Bonding in this context is wafer-to-wafer bonding where whole wafers are aligned and bonded together such that individual dies on each wafer are aligned. The concept of wafer-to-wafer bonding is known and used in many IC manufacturing processes. The bonding tool 440 may comprise a bonding alignment device for aligning the wafers together for bonding. For example, the bonding tool 440 may perform pre-align using box-in-box marks provided to wafers (e.g., one box on each wafer), with visual inspection of marks used for alignment quality/ position control. Another method uses two imaging sensors (e.g., face to face) which are first calibrated together to find their relative positions; each sensor is then used to separately align a respective substrate to be bonded.

Such bonding may comprise any type of bonding process. Known bonding processes include hybrid Cu-Cu (copper-to-copper) bonding and aligned fusion bonding with post-bonding TSV (through-silicon via) interconnect. Hybrid Cu-Cu bonding may comprise bonding together (e.g., copper) respective bonding pads (interconnects) at a bonding interface, the bonding interface further comprising a dielectric layer between the substrates being bonded. Aligned fusion bonding comprises precisely aligning two substrates with matching patterns before bonding them together. TSVs are then exposed and formed on the bonded substrate.

Once bonded, the resultant bonded substrate may be measured using a metrology apparatus 450 (which may be the same metrology apparatus as either of metrology apparatuses 410a, 410b or otherwise). Such metrology may comprise measuring bonding overlay. Bonding overlay therefore describes relative positioning offsets (errors) in features (e.g., interconnects) of two bonding layers; i.e., the position of features of the bonding layer of a first substrate with respect to the position of features of the bonding layer of a second substrate which is to be bonded to the first substrate. This is in contrast to (conventional) overlay which measures the relative positioning of features within two layers of a single substrate.

Corrections can then be calculated for improving bonding overlay, which can then be fed back to the bonding tool 440 to improve the bonding process and bonding overlay for subsequent bonded substrates. Such corrections may comprise linear corrections as the bonding tool may be capable of implementing only linear correction. However, proposed bonding tools may be capable of correcting higher order bonding overlay fingerprints (although probably not the full range of correction potential of a scanner), and therefore the bonding overlay corrections may be higher order when the bonding tool allows this.

For some processes, e.g., those which employ post-bonding TSV, there may be a further lithographic step on the bonded substrate using another lithographic processing system 460 (which may be the same as either of lithographic processing systems 400a, 400b or otherwise), to form the vias (and/or to further pattern the bonded substrate). The patterns formed in this further lithographic step may also be measured using metrology apparatus 470 (which may be the same metrology apparatus as any of metrology apparatuses 410a, 410b, 450 or otherwise), so as to determine feedback corrections for the further patterning process. This metrology may measure post-bonding overlay. Post-bonding overlay describes the relative position of features formed on the bonded substrate after bonding, with respect to features of the bonded substrate formed prior to bonding.

The present methods for manufacturing bonded substrates, as outlined in Figure 4, are sufficient for meeting present bonding overlay and/or post-bonding overlay requirements. However, future requirements are expected to be increasingly stringent. For example, increased interconnect density between the two substrates is becoming more important to enable support for high bandwidth applications such as, e.g., artificial intelligence (AI) engines. The interconnect density pitch and CD of copper interconnection pads or TSVs is in part enabled by the accuracy of the bonding tool's ability to position the respective Cu pad/TSVs grids for the two substrates.

Figure 5 illustrates the problem with the present method as interconnect density increases and therefore bonding overlay requirements become more stringent. The figure shows first (e.g., copper) interconnects 500 in the bonding layer of a first substrate and second (e.g., copper) interconnects 510 in the bonding layer of a second substrate. There is a magnification (scaling) error difference between these two bonding layers. This results in a failed interconnection 520 and therefore a probable defective die.

Bonding tool stability and bonding tool matching are each expected to significantly impact bonding overlay and/or post-bonding overlay budgets. Presently, the bonding overlay and post-bonding overlay budgets are sufficiently relaxed, such that these stability and matching impacts can be absorbed within the present budget. However, this will not be the case when the bonding overlay requirements become more stringent.

It is therefore proposed to monitor and correct for drift in the bonding tool, and/or performing bonding tool matching to correct for differences in the bonding tools. Such a method may aim to minimize the bonding tool contribution to the overlay budget, and therefore improve the device layer overlay performance (bonding overlay and/or post-bonding overlay).

The proposed method comprises manufacturing a monitor bonded substrate using at least one bonding tool and using the monitor bonded substrate to monitor and correct for drift of the bonding tool(s) over time and/or to monitor and correct for differences between different bonding tools.

The method comprises obtaining first bonding tool monitor data describing distortion imposed by a first bonding tool at a first time; obtaining second bonding tool monitor data describing distortion imposed by the first bonding tool at a second time and/or distortion imposed (at least one) second bonding tool; and determining a correction for manufacturing one or more subsequent bonded substrates using said first bonding tool and/or said second bonding tool from the first bonding tool monitor data and second bonding tool monitor data.

The method may comprise monitoring of bonding tool drift over time, e.g., the drift in control grid distortion imposed by a bonding tool over time. In such an embodiment, the second bonding tool monitor data may describe distortion imposed by the first bonding tool at (at least) a second time and the correction determined for manufacturing one or more subsequent bonded substrates using said first bonding tool at said (at least a) second time. This may be repeated routinely at other times subsequent to said second times (e.g., at a third time, fourth time etc.), to monitor bonding tool drift between these times.

The method may be implemented by exposing, bonding and measuring bonding tool monitor substrates at each of the first, second and subsequent times. Bonding tool monitor substrates may comprise a large number of features (e.g., metrology targets) which enable alignment and overlay type measurements to be made. Such bonding tool monitor substrates comprise bonded substrates. Manufacturing the bonding tool monitor substrates may comprise exposing a pair of substrates on one or more lithographic apparatuses, e.g., the two substrates may be exposed on respective different lithographic apparatuses or the same lithographic apparatus. The two substrates may be further processed (e.g., etched) and then bonded together. Optionally, there may be a further processing (e.g., grinding) and lithography step, e.g., for forming vias in a TSV process.

The bonding tool monitor data at each said time (e.g., the first bonding tool monitor data, second bonding tool monitor data and any subsequent bonding tool monitor data) may comprise one or both of absolute bonding tool monitor data describing the absolute position of features within the respective bonding layers of each of a pair of constituent substrates which are to be bonded to form the bonding tool monitor substrates, and/or relative bonding tool monitor data describing the relative position of features within these bonding layers.

The absolute bonding tool monitor data may describe a difference of pre-bond absolute bonding tool monitor data and post-bond absolute bonding tool monitor data. The pre-bond absolute bonding tool monitor data comprise pre-bond alignment data from the respective bonding layers of the two constituent substrates and therefore describe the absolute control (i.e., alignment) grids of the respective bonding layers prior to bonding. Similarly, the post-bond absolute bonding tool monitor data comprise post-bond alignment data from the respective bonding layers of the two constituent substrates and therefore describe the absolute control (i.e., alignment) grids of the respective bonding layers after bonding. As such, this difference should describe the control grid distortion of each substrate which is imposed by the bonding tool (i.e., the overall grid distortion with the lithographic apparatus/etching related grid distortion subtracted therefrom).

The relative bonding tool monitor data may comprise relative bonding overlay data; e.g., relative control grid data between the bonding layers of the bonding tool monitor substrates.

The post-bond absolute bonding tool monitor data and the relative bonding tool monitor data may comprise such data immediately after bonding, e.g., before any processing such as grinding for further exposure (if this is to be done) and/or after such processing/grinding.

Respective bonding tool monitor substrates may be provided for each bonding tool, for individually monitoring drift of each bonding tool of a fleet of one or more bonding tools in isolation. However, in some embodiments, one of the bonding tools (e.g., the first bonding tool) may be designated as a reference bonding tool (or "golden" bonding tool), and bonding tool matching data defined as the difference between the first bonding tool monitor data (at the first time) describing metrology control grid distortion imposed by the first bonding tool and at least second bonding tool monitor data describing metrology control grid distortion imposed by at least the second bonding tool. Respective sets of bonding tool matching data can similarly be determined for each of other bonding tools of the fleet. In this way, the bonding tool monitor data (control grid) can be commonly defined over the fleet of bonding tools, as defined from the bonding tool monitor data measured from each bonding tool's monitor substrate, as corrected by each bonding tool's matching data. In this manner, every bonding tool in a fabrication site (fab), regardless of type, model and of grid differences, can be matched to this golden reference, increasing fab efficiency significantly.

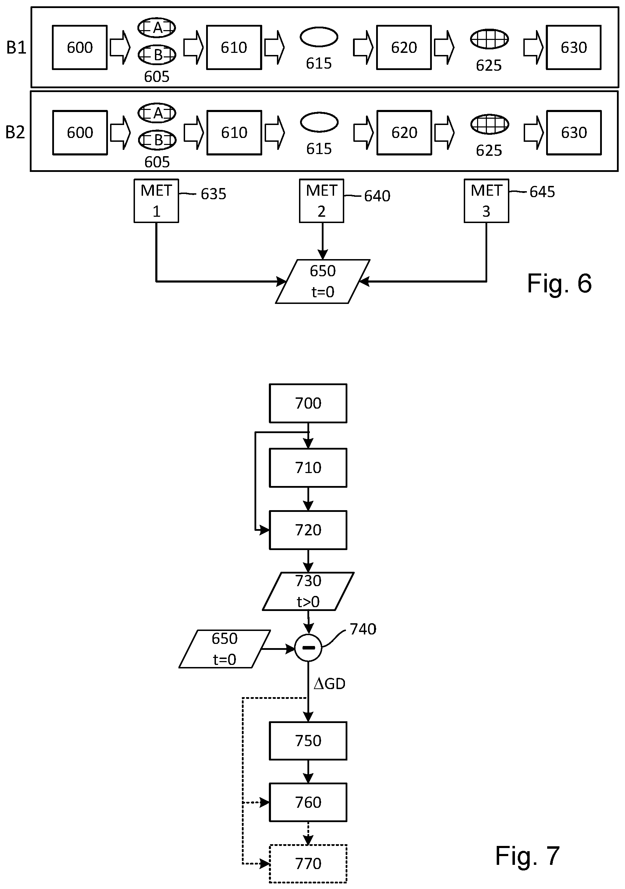

Figure 6 is a flow diagram illustrating a first stage (setup stage) of a proposed method disclosed herein. For each of a fleet of bonding tools, an initial bonding tool monitor substrate is manufactured and measured to obtain initial bonding tool monitor data. In the specific example shown, there are two monitor substrate flows respectively for each of two bonding tools B1, B2. It can be appreciated that the method is also applicable to a single bonding tool, to monitor and correct drift of that single bonding tool.

The manufacture of the bonding tool monitor substrate, per bonder, comprises exposing and processing 600 (e.g., *inter alia* etching) the constituent substrates 605 which are to be bonded together. These substrates 605 (e.g., substrate A and substrate B) may each comprise various metrology target structures in a bonding layer of the substrate. Such substrates may comprise a large number of such targets, to enable dense metrology. The targets may be suitable for one or both of alignment metrology and bonding overlay metrology. At step 610, the substrates 605 are bonded together to obtain bonding tool monitor substrate 615. Optional further steps may comprise a further processing step 620, e.g., back-side grinding step 620 to grind the bonding tool monitor substrate 615, thereby obtaining a ground bonding tool monitor substrate 625. Further lithography 630, e.g., to expose vias, may then be performed depending on the bonding process used.

To obtain the e.g., first or initial bonding tool monitor data, metrology is performed at points during this flow. For each of the bonding tool flows M1, M2, a first metrology step 635 is performed on each of the constituent substrates 605 prior to bonding (to obtain the pre-bond absolute bonding tool monitor data). At least one further metrology step 640, 645 is performed respectively on one or both of the bonding tool monitor substrate 615 and processed (post-grinding) bonding tool monitor substrate 620, to obtain the post-bond absolute bonding tool monitor data and/or relative bonding tool monitor data.

Metrology step 635 may comprise performing alignment metrology on the substrates 605 so as to characterize their respective control grids after lithography. A standard alignment sensor may be used. Wavelengths used to measure substrates may be, for example, in the visible and/or infra-red bands. At each (or either one) of metrology steps 640, 645, similar alignment metrology may be performed to characterize their respective control grids after bonding. The control grids measured at step 635 can then be subtracted from the control grids measured at step 640 to isolate the grid distortion caused by the bonding process (and therefore bonding tool). Similarly, The control grids measured at step 635 can then be subtracted from the control grids measured at step 645 to isolate the grid distortion caused by a combination of the bonding process and grinding process and/or the control grids measured at step 640 can then be subtracted from the control grids measured at step 645 to isolate the grid distortion caused by the grinding process.

Each of metrology steps 640, 645 may further comprise bonding overlay metrology to obtain bonding overlay data of the bonding tool monitor substrate before and/or after grinding (i.e., to measure the relative control grids). Metrology steps 640, 645 may use conventional alignment and/or overlay metrology tools which are able to use infra-red wavelengths and therefore able to measure through the backside of the bonded substrate. Visible wavelengths may also be used for step 645, at least for the side ground for exposure.

The result of this process and metrology steps 635, 640, 645 is first or initial bonding tool monitor data 650 relating to an initial time (e.g., first time) t=0. This initial bonding tool monitor data may represent a baseline against which bonder tool drift may be monitored. The baseline or reference absolute control grid (alignment grid) for drift monitoring may comprise the control grid of either of the constituent substrates of the bonding tool monitor substrate.

Matching data sets may be determined between the first bonding tool and second bonding tool which match the bonding tool fingerprint (e.g., as represented by the difference of absolute grids after and before bonding, and/or represented by the bonding overlay grid) of the second bonding tool (and other bonding tools of the fleet) to the first bonding tool (reference or golden bonding tool). Of course, any bonding tool of the fleet may be designated as the golden bonding tool. Drift of all bonding tools of the bonding tool fleet may be determined with respect to the baseline defined by this golden bonding tool. As such, the matching data set may comprise a comparison or difference of first initial bonding tool monitor data describing distortion imposed by the first bonding tool and (at least one) set of second initial bonding tool monitor data describing distortion imposed by (e.g., each) said second bonding tool at the initial time.

Figure 7 illustrates methods of bonding tool drift control and/or bonder tool matching using the initial bonding tool monitor data 650. A number of variations may be envisaged, e.g., depending on whether further processing and lithography is to be performed on the bonded substrate (e.g., fusion bonding with TSV) or not (e.g., hybrid Cu-Cu bonding).

After a time period over which bonding tool parameters may have drifted (e.g., after manufacture of a lot of bonded substrates, a number of lots of bonded substrates, a day or a number of days), a new bonding tool monitor substrate is manufactured; e.g., two substrates comprising dense metrology targets are exposed, etched and bonded together in the same manner as described in relation to Figure 6. As such, this new bonding tool monitor substrate may be essentially similar to that manufactured at time t=0 (i.e., comprise the same metrology targets at the same locations).

More specifically, a pair of substrates may be exposed and etched 700, and then bonded 710 together. Metrology 720 is performed on the pair of substrates before bonding 710 and after bonding 710, and the difference of these metrology sets is determined, so as to determine later bonding tool monitor data 730 e.g., the bonding tool induced absolute grid at t>0. As with the initial bonding tool monitor data 650, the later bonding tool monitor data 730 may also comprise relative grid data (e.g., overlay data).

At step 740, the later bonding tool monitor data 730 at t>0 is compared to the baseline initial bonding tool monitor data 650, e.g., to determine difference grid data ΔGD (e.g., one or both of the absolute grids and overlay grids). The difference grid data ΔGD may then be used to determine correction for lithography 750 of one or both of the constituent substrates which are to be bonded together 760 in the high-volume bonded substrate manufacturing process being monitored. These corrections are implemented to correct for drift within the bonding tool, e.g., based on an assumption that any changes over time (and/or between bonding tools) is attributable to the bonding tools.

It is also possible that at least one or more (e.g., linear) component of the correction can be forwarded to the bonding tool to be implemented during the bonding process, e.g., a co-optimized correction of lithography (one or both substrates) and bonding is also envisaged. It can be appreciated, however, that the correction potential is typically greater within a lithographic apparatus, which is capable of higher order corrections whereas a typical bonding tool can implement only linear correction.

In some embodiments, the bonded substrate will undergo grinding and further lithography 770, e.g., to form vias and/or other structures. In such a case, the correction derived from the difference grid data ΔGD may be applied during this further lithography step 770, either instead of or additionally to application during lithography 750 of one or both of the constituent substrates (and/or additionally to correction during bonding 760).

As such, a correction as determined using the methods disclosed herein may be optimized for implementation in any one of, or co-optimized for implementation in any combination of two or more of: a first lithography apparatus used to expose a first constituent substrate at step 750, a second lithography apparatus used to expose a second constituent substrate at step 750, a bonding tool used to bond together the first and second constituent substrates, a third lithography apparatus used to expose the bonded substrate after bonding and/or any other manufacturing device used in the manufacture of the bonded substrate and which has correction capability (e.g., either of the etch tools used at step 750 and/or an etch tool used at step 770).

This flow can be implemented routinely, to correct for drift at routine intervals.

The method flow of Figure 7 can be performed in isolation for each bonding tool in a bonding tool fleet, to correct drift of each bonding tool to a respective different baseline, as described by the initial bonding tool monitor data 650. Alternatively, one of the bonding tools (e.g., bonding tool B1, although the choice is arbitrary) can be designated as the reference bonding tool (golden bonding tool). In such an example, one of the alignment grids measured at step 635 may be designated as the reference control grid, such that all other control grids may be referenced with respect to this control grid.

In such an embodiment, the same initial bonding tool monitor data 650, measured from one bonding tool flow (e.g., corresponding to bonding tool B1 in Figure 6) can be used for monitoring drift of multiple bonding tools (e.g., both bonding tools B1, B2 in Figure 6). In such a case, the initial bonding tool monitor data 650 may comprise respective sets of matching data for each bonding tool to be monitored other than the golden bonding tool, the matching data matching the performance of each bonding tool to the golden bonding tool.

Such a method as described herein may therefore be used to minimize variability of (on product) overlay by calibrating the bonding tools (in terms of stability and/or matching). As such, an improved calibrated status of bonding tools is obtained which reduces the bonding tool variation contribution to the total overlay budget.

Further embodiments of the invention are disclosed in the following list of numbered clauses:
1. A method for determining a correction for manufacturing one or more bonded substrates, the method comprising: obtaining initial bonding tool monitor data describing distortion imposed on the one or more bonded substrates by at least a first bonding tool at an initial time; obtaining second bonding tool monitor data describing distortion imposed by the first bonding tool at a second time subsequent to said initial time and/or distortion imposed by at least one second bonding tool; and determining a correction for manufacturing one or more subsequent bonded substrates using at least said first bonding tool and/or said at least one second bonding tool from the initial bonding tool monitor data and second bonding tool monitor data.
2. A method according to clause 1, wherein said second bonding tool monitor data describes distortion imposed by at least the first bonding tool at said second time, and said correction corrects at least for drift of one or more parameters in said at least the first bonding tool.
3. A method according to clause 2, wherein: said initial bonding tool monitor data relates to an initial monitor bonding substrate which was manufactured using said first bonding tool to bond an initial pair of constituent substrates at the initial time; and said second bonding tool monitor data relates to at least one second monitor bonding substrate which was manufactured using said first bonding tool to bond a second pair of constituent substrates at the second time.
4. A method according to clause 3, comprising measuring said initial monitor bonding substrate and at least one second monitor bonding substrate to obtain said initial bonding tool monitor data and said second bonding tool monitor data.
5. A method according to clause 3 or 4, comprising manufacturing the initial monitor bonding substrate at said initial time by exposing and processing the initial pair of constituent substrates and on one or more lithographic apparatuses and bonding said initial pair of constituent substrates together; and manufacturing the at least one second monitor bonding substrate at said second time by exposing and processing the second pair of constituent substrates and on one or more lithographic apparatuses and bonding said second pair of constituent substrates together.
6. A method according to any preceding clause, wherein said initial bonding tool monitor data and second bonding tool monitor data comprises one or both of absolute bonding tool monitor data describing the absolute position of features within the respective bonding layers of each said constituent substrate; and/or relative bonding tool monitor data describing the relative position of features within said bonding layers.
7. A method according to clause 6, wherein said absolute bonding tool monitor data describes a difference of pre-bond absolute bonding tool monitor data, as measured from said constituent substrates prior to bonding and post-bond absolute bonding tool monitor data as measured from said constituent substrates after bonding.
8. A method according to clause 7, wherein said post-bond absolute bonding tool monitor data and the relative bonding tool monitor data comprises such data measured immediately after bonding and/or measured after a grinding step to prepare the bonded substrate for further lithography.
9. A method according to any of clauses 6 to 8, wherein said absolute bonding tool monitor data comprises alignment data.
10. A method according to any of clauses 6 to 9, wherein said relative bonding tool monitor data comprises bonding overlay data.
11. A method according to any preceding clause, wherein said second bonding tool monitor data describes distortion imposed by each at least one second bonding tool at said second time, and further comprises respective sets of matching data for each said at least one second bonding tool; and wherein each said set of matching data corrects said initial bonding tool monitor data corresponding to said first bonding tool so as to represent initial bonding tool monitor data at the initial time which corresponds to the respective second bonding tool for that set of matching data.
12. A method according to clause 11, comprising determining said sets of matching data by:
   obtaining first initial bonding tool monitor data describing distortion imposed on the one or more bonded substrates by the first bonding tool at an initial time;
   obtaining respective second sets of initial bonding tool monitor data describing distortion imposed on the one or more bonded substrates by each said second bonding tool at the initial time; and
   determining each set of matching data respectively from a comparison or difference of each second set of initial bonding tool monitor data and said first initial bonding tool monitor data.
13. A method according to any preceding clause, comprising using said correction in manufacturing bonded substrates from pairs of constituent substrates in a manufacturing process.
14. A method according to clause 13, wherein said correction is optimized or co-optimized for correcting exposure and/or etch of one or both constituent substrates of each pair of constituent substrates.
15. A method according to clause 13 or 14, wherein said correction is optimized or co-optimized for correcting bonding of the constituent substrates.
16. A method according to clause 13, 14 or 15, wherein said correction is optimized or co-optimized for exposure of the bonded substrates after bonding.
17. A method according to any preceding clause, comprising performing said method routinely at one or more further times subsequent to said second time.
18. A computer program comprising program instructions operable to perform the method of any of clauses 1 to 17, when run on a suitable apparatus.
19. A non-transient computer program carrier comprising the computer program of clause 18.
20. A processing apparatus comprising: at least one processor; and the non-transient computer program carrier according to clause 19.
21. A bonded substrate manufacturing apparatus comprising: one or more lithographic apparatuses; at least one bonding apparatus; one or more metrology apparatuses; and the processing apparatus of clause 20.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

**1.** A method for determining a correction for manufacturing one or more bonded substrates, the method comprising:
obtaining initial bonding tool monitor data describing distortion imposed on the one or more bonded substrates by at least a first bonding tool at an initial time;
obtaining second bonding tool monitor data describing distortion imposed by the first bonding tool at a second time subsequent to said initial time and/or distortion imposed by at least one second bonding tool; and
determining a correction for manufacturing one or more subsequent bonded substrates using at least said first bonding tool and/or said at least one second bonding tool from the initial bonding tool monitor data and second bonding tool monitor data.

**2.** A method as claimed in claim 1, wherein said second bonding tool monitor data describes distortion imposed by at least the first bonding tool at said second time, and said correction corrects at least for drift of one or more parameters in said at least the first bonding tool.

**3.** A method as claimed in claim 2, wherein: said initial bonding tool monitor data relates to an initial monitor bonding substrate which was manufactured using said first bonding tool to bond an initial pair of constituent substrates at the initial time; and said second bonding tool monitor data relates to at least one second monitor bonding substrate which was manufactured using said first bonding tool to bond a second pair of constituent substrates at the second time.

**4.** A method as claimed in claim 3, comprising measuring said initial monitor bonding substrate and at least one second monitor bonding substrate to obtain said initial bonding tool monitor data and said second bonding tool monitor data.

**5.** A method as claimed in claim 3, comprising manufacturing the initial monitor bonding substrate at said initial time by exposing and processing the initial pair of constituent substrates and on one or more lithographic apparatuses and bonding said initial pair of constituent substrates together; and manufacturing the at least one second monitor bonding substrate at said second time by exposing and processing the second pair of constituent substrates and on one or more lithographic apparatuses and bonding said second pair of constituent substrates together.

**6.** A method as claimed in claim 1, wherein said initial bonding tool monitor data and second bonding tool monitor data comprises one or both of absolute bonding tool monitor data describing the absolute position of features within the respective bonding layers of each said constituent substrate; and/or relative bonding tool monitor data describing the relative position of features within said bonding layers.

**7.** A method as claimed in claim 6, wherein said absolute bonding tool monitor data describes a difference of pre-bond absolute bonding tool monitor data, as measured from said constituent substrates prior to bonding and post-bond absolute bonding tool monitor data as measured from said constituent substrates after bonding.

**8.** A method as claimed in claim 7, wherein said post-bond absolute bonding tool monitor data and the relative bonding tool monitor data comprises such data measured immediately after bonding and/or measured after a grinding step to prepare the bonded substrate for further lithography.

**9.** A method as claimed in claim 6, wherein said absolute bonding tool monitor data comprises alignment data and/or overlay data.

**10.** A method as claimed in claim 1, wherein said second bonding tool monitor data describes distortion imposed by each at least one second bonding tool at said second time, and further comprises respective sets of matching data for each said at least one second bonding tool, and wherein each said set of matching data corrects said initial bonding tool monitor data corresponding to said first bonding tool so as to represent initial bonding tool monitor data at the initial time which corresponds to the respective second bonding tool for that set of matching data.

**11.** A method as claimed in claim 10, comprising determining said sets of matching data by:
obtaining first initial bonding tool monitor data describing distortion imposed on the one or more bonded substrates by the first bonding tool at an initial time;
obtaining respective second sets of initial bonding tool monitor data describing distortion imposed on the one or more bonded substrates by each said second bonding tool at the initial time; and
determining each set of matching data respectively from a comparison or difference of each second set of initial bonding tool monitor data and said first initial bonding tool monitor data.

**13.** A method as claimed in claim 1, comprising using said correction in manufacturing bonded substrates from pairs of constituent substrates in a manufacturing process.

**14.** A computer program comprising program instructions operable to perform the method of claim 1, when run on a suitable apparatus.

**15.** A non-transient computer program carrier comprising the computer program of claim 14.
